(19) **Europäisches Patentamt**

**European Patent Office**

**Office européen des brevets**

(11) **EP 0 858 180 A2**

(12) **EUROPÄISCHE PATENTANMELDUNG**

(43) Veröffentlichungstag:
12.08.1998 Patentblatt 1998/33

(51) Int. Cl.⁶: **H04L 1/00**

(21) Anmeldenummer: 98101709.8

(22) Anmeldetag: 02.02.1998

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: **05.02.1997 DE 19706041**

(71) Anmelder:
**DeTeWe - Deutsche Telephonwerke Aktiengesellschaft & Co.**
**10997 Berlin (DE)**

(72) Erfinder: **Schioler, Henrik**
**9800 Hjorring (DK)**

(54) **Verfahren zum Stummschalten von Höreinrichtungen in mobilen Kommunikations-Endgeräten**

(57)    Ein Verfahren zum Stummschalten von Höreinrichtungen in mobilen Kommunikations-Endgeräten, deren Funkschnittstelle zwischen Basisstation und Endgerät den DECT-Standard für das Übertragungsverfahren anwendet und das mit einer ADPCM-Datenabtastung arbeitet, ist dadurch gekennzeichnet, daß im Kontrolldatenfeld (A-Feld) jedes gesendeten DECT-Luftschnittstellenrahmens zur Ermittlung der Bit-Fehlerrate (BER) für eine zyklische Blockprüfung eine feste Anzahl von Nachrichteneinheiten als ACRC-Feld vorgesehen ist, wobei dem ACRC-Feld unmittelbar das Trägerfeld (B-Feld) für das Audio-Signal folgt.

```
  A-Feld          B-Feld                         X-  Z-
                                                    Feld

 ┌──────────┬──────┬───────────────────────────┬──────┬──────┐
 │ 48bit    │ ACRC │        320 bit            │ BCRC │      │
 │          │ 16bit│                           │ 4bit │ 4bit │
 └──────────┴──────┴───────────────────────────┴──────┴──────┘
```

FIG. 2

Printed by Xerox (UK) Business Services
2.16.3/3.4

EP 0 858 180 A2

**Beschreibung**

Die Erfindung bezieht sich auf ein Verfahren zum Stummschalten von Höreinrichtungen in mobilen Kommunikations-Endgeräten gemäß Oberbegriff des Patentanspruches 1.

Für schnurlose Telekommunikationsanlagen ist ein europaischer Standard festgelegt, der die Übertragungsverfahren und die Frequenzbänder zur schnurlosen Kommunikation in analogen und digitalen Telefonnetzen umfaßt. Dieser DECT-Standard (Digital Europeen Cordless Telecommunication) bezieht sich auf die Funkschnittstelle zwischen mobilen Endgeräten und einer an ein Telekommunikationssystem fest angeschlossenen Basisstation. Die Tonqualität der schnurlosen Übertragungsstrecke zwischen Endgerät und Basisstation kann verbessert werden, indem im Fall fehlerhafter Übertragung von Audiodaten deren Wiedergabe abgeschaltet wird.

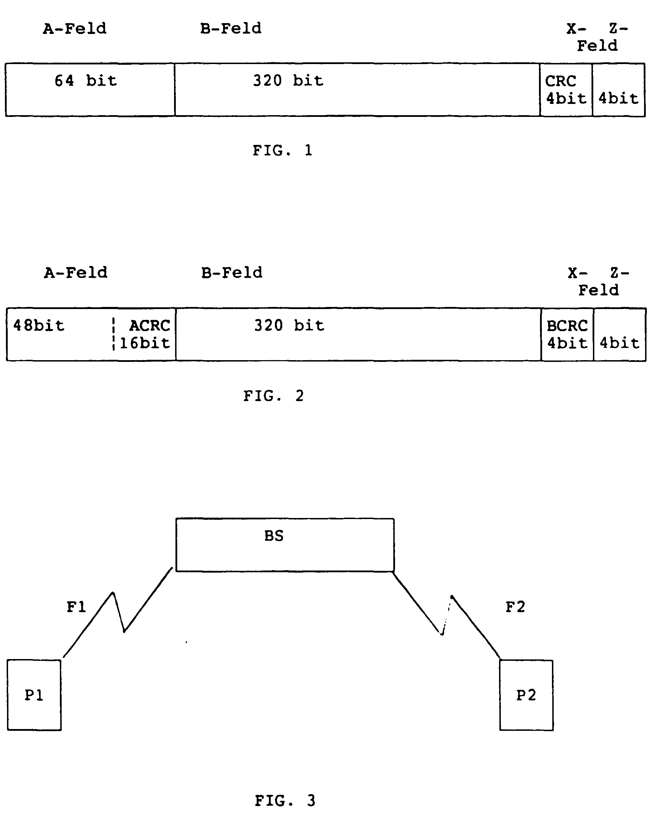

In einer Variante kommerziell verfügbarer DECT-Hardware ist eine Geräuschsperre vorgesehen, die auf einr Modulation von CRC-Fehlern in verschiedenen Feldern beruht, die durch den Standard-DECT-Rahmen (Figur 1) begrenzt sind. Die CRC-Prüfung (Cyclic Redundancy Check) ist ein bekanntes System der Fehlerkontrolle, die auf der Sende- und Empfangsstation eine Blockprüfung beinhaltet. Wenn die Tonqualität in Beziehung zur Bit-Fehlerrate (BER) betrachtet wird, ist diese Größe BER von Bedeutung für jeden Dämpfungs- bzw. Stummschalt-Algorithmus. Die Bit-Fehlerrate BER ist beim Empfänger unbekannt und muß indirekt aus den gemessenen Signalen ermittelt werden als ein Ergebnis der CRC-Berechnung. Sobald der CRC-Algorithmus einen ausreichenden leistungsfähigen Wert erreicht hat, sind folgende Schlüsse begründet:

1. Wenn die CRC-Berechnung keinen Fehler anzeigt, sind keine Bit-Fehler im zugeordneten Rahmen aufgetreten;
2. wenn die CRC-Berechnung einen Fehler angibt, dann sind zwischen dem ersten und allen folgenden Bits im zugeordneten Rahmenfeld Fehler vorhanden.

Im ersten Fall wird der Ton nicht stumm geschaltet. Im zweiten Fall liegt im Grunde beim Empfänger kein Wissen vor und über eine Stummschaltung kann vom Empfänger nicht entschieden werden, da das Ergebnis der CRC-Berechnung unbekannt ist.

Eine mögliche Losung des Problems besteht darin, daß angenommen wird, daß der Übertragungszustand über eine kleinere Anzahl von Rahmenperioden unverändert bleibt. In diesem Fall kann die Bit-Fehlerrate BER statistisch vom CRC-Verlauf hergeleitet werden. Die Entscheidung über die Stummschaltung wird dann durch z. B. lineare Filterung oder eine Entscheidungstabelle erreicht. Diese bekannte Lösung enthält jedoch eine wechselseitige Beeinflussung zwischen statistischer Genauigkeit und der Meßzeit. Das heißt, wenn eine große Zahl von CRC-Ergebnissen genutzt wurde, kann die Bit-Fehlerrate BER für stationäre Übertragungszustände präzise hergeleitet werden, aber die Meßzeit für einen Wechsel von Übertragungszuständen ist erheblich. Im anderen Fall, wenn wenige CRC-Ergebnisse genutzt wurden, wird die Bit-Fehlerrate BER nur mit einer großen statistischen Unsicherheit erkannt, während eine schnelle Erwiderung zum Wechsel der Übertragungszustände erwartet wird.

Der Erfindung lag die Aufgabe zugrunde, ein Verfahren anzugeben, daß sowohl eine statistische präzise Ermittlung der Bit-Fehlerrate als auch eine schnelle Reaktion auf Veränderung der Übertragungszustände umfaßt.

Diese Aufgabe wird durch die Erfindung gelöst, wie sie im Kennzeichnungsteil des ersten Patentspruches dargelegt ist. Weitere vorteilhafte Merkmale sind Gegenstand der Unteransprüche.

Anhand einer aus sechs Figuren bestehenden Zeichnung wird die Erfindung nachfolgend näher erläutert. In der Zeichnung zeigen die

Fig. 1     die schematische Darstellung eines DECT-Standard-Übertragungsrahmens, die
Fig. 2     die Unterteilung des DECT-Standard-Übertragungsrahmens gemäß der Erfindung, die
Fig. 3     eine schematisch dargestellte Kommunikationsanlage, die
Fig. 4     die grafische Darstellung einer ACRC-basierten BER-Schätzung, die
Fig. 5     die grafische Darstellung einer ADPCM-basierten BER-Schätzung und die
Fig. 6     die kombinierte BER-Schätzung aus den Figuren 4 und 5.

Der Standard-DECT-Luftschnittstellenrahmen (Fig. 1) besteht aus einem 64 bit-A-Feld für Kontrolldaten, einem 320 bit-B-Feld als Träger für das Audiosignal, ein 4 bit-X-Feld mit CRC-Kontrollbits für das B-Feld und einem 4 bit-Z-Feld für gleitende Fehlererfassungen. Die X- und Z-Felder sind aus verschiedenen Gründen für eine Bit-Fehlerratenschätzung nicht geeignet. Statt dessen wird zur Ermittlung der BER ein 16 bit-CRC-Feld verwendet, das im A-Feld eingeschlossen ist, im weiteren Text als ACRC-Feld bezeichnet (Fig. 2).

Im folgenden wird definiert, daß die Bit-Fehlerrate BER die Anzahl der fehlerhaft empfangenen Bits dividiert durch die Anzahl der übertragenen Bits ist. Weiterhin ist eine Wahrscheinlichkeit $C(j)$ definiert, dessen Wert $C(j) = 1$ ist, wenn ein ACRC-Fehler im gerade empfangenen Rahmen ermittelt wurde und $C(j) = 0$ ist, wenn kein Fehler aufgetreten ist. Ein Verlauf von ACRC-Feldern ist protokolliert in dem gefilterten Signal $Cf(j)$, das festgelegt ist zu

$$Cf(j)=a*Cf(j-1)+(1-a)*C(j-1)$$

und das als unimodular und symmetrisch verteilt um seinen Zeitmittelwert angesehen wird. Dementsprechend ist eine Variable Cb(j) definiert als

$$Cb(j)=inv\ G[Cf(j)],$$

die eine maximale Likelihood-Schätzfunktion der Bit-Fehlerrate darstellt. Ein vernünftiger Stummschalt-Algorithmus wird eine Hörerstummschaltung aktivieren, wenn die Bit-Fehlerrate BER einen oberen Wert überschreitet. Wenn die Bit-Fehlerrate BER nur durch wenige Schätzungen bekannt ist, wird der Algorithmus die Hörerstummschaltung aktivieren, wenn Cb(j) > BERmax ist. Die Stummschaltung ist somit abhängig von der Qualität der BER-Schätzung, die durch einen Wert B gemessen wird:

$$B=E[(BERest-BER)^2]=[std(BERest)]^2+[E(BERest)-BER]^2$$

Darin ist std die Standard-Abweichung mit $std(x)=\sqrt{VAR(x)}$, worin die Abweichung $VAR(x)=E\{[x-E(x)]^2\}$ mit E als statistischen Erwartungswert. BERest sind einige Schätzungen der Bit-Fehlerrate BER anhand empirisch ermittelter Werte. Es ist nachzuweisen, daß für die geschätzte Cb nach vorheriger Definition der erste Wert von B klar dominiert, so daß die Qualität der Schätzung nur von der Standard-Abweichung std abhängt. Ist die Standard-Abweichung std der Bit-Fehlerraten-Schätzung BER zu groß, wird der Stummschalt-Algorithmus hin und wieder dann stumm schalten, wenn nur ein kleiner Bit-Ratenfehler vorhanden ist und läßt umgekehrt ein stark verfälschtes Audiosignal zum Hörer durch. Die Erfindung verbessert die Qualität der BER-Schätzung die den Stummschalt-Algorithmus leitet, durch Voranstellen und Auswerten des ACRC-16-bit-Feldes jedes gesendeten DECT-Rahmens.

Bei der Audio-Übertragung im DECT-System wird der analoge Ton durch 16 Bits mit einer Frequenzrate von 8 kHz abgetastet. Die 16-bit-Datenabtastungen sind ADPCM-codiert (Adaptiv Difference Puls Code Modulation). Die ADPCM-Codierung wandelt jede 16-bit-Abtastprobe in 4 Bits um. 80 4-bit-ADPCM-Abtastungen werden in jedem DECT-Rahmen gesendet (4x8=320 bits des B-Feldes, Fig. 2), der auf diesem Weg 10 ms des Tones überträgt. Die 4-bit-ADPCM-Abtastung ist statistisch unabhängig und genau verteilt auf die ADPCM-Codierung.

Passend zur Zweierkomplement-Auswertung der übertragenen Symbole wird eine Null nicht übertragen. Die Schätzung der Bit-Fehlerrate der ADPCM-Abtastung geschieht anhand der Tatsache, daß eine Null des Zweierkomplements 1,0 nicht übertragen wird. Dies erlaubt es, für die Empfangsseite die Bit-Fehlerrate anhand der Anzahl von empfangenen Nullen abzuschätzen, da es sich in einem solchen Fall offensichtlich um einen Übertragungsfehler handeln muß. Wenn hierbei die Anzeigevariable definiert ist als

$$Z=(N0/N)\ /\ (Nx/N)\ mit$$

$$Nx=N1+N2+N4+N8,\ wobei$$

Nj die Zahl der empfangenen Zeichen mit einem Wert j der kürzlich gesendeten Rahmen und N die komplette Anzahl von Zeichen je Rahmen ist, im vorliegenden Fall 80 Abtastungen. Die Zeichenwerte 1, 2, 4, 8, die in der Definition von Nx erscheinen, sind ausgewählt, weil für den Sicherheitsabstand (Hamming-Abstand) H(k,j) in der Datenübertragung zwischen den Zeichenwerten k und j gilt:

$$H(0,j)=1\ für\ j=1,2,4,8.$$

Nachfolgend werden die Fähigkeiten der Anzeige-Variable als eine Bit-Fehleranzeige diskutiert. Die Durchschnittswerte des Nominators N0 und des Denominators Nx sind näherungsweise wie folgt gegeben

$$E(N0)=N*Pr(0)$$

$$Pr(0)=BER*(1-BER)^3*[Pt(1)+Pt(2)+Pt(4)+Pt(8)]$$

$$E(Nx)=N*[Pr(1)+Pr(2)+Pr(4)+Pr(8)]$$

$$Pr(1)+Pr(2)+Pr(4)+Pr(8)=Pr(x)$$

$$Pr(x)=[Pt(1)+Pt(2)+Pt(4)+Pt(8)]^*(1\text{-}BER)^4 +\{Pt[I(1,1)]+Pt[I(1,2)]+Pt[I(1,3)]+Pt[I(1,4)]+$$
$$Pt[I(2,1)]+\ldots\ldots\ldots\ldots+Pt[I(2,4)]+ Pt[I(4,1)]+\ldots\ldots\ldots\ldots+Pt[I(4,4)]+ Pt[I(8,1)]+\ldots\ldots\ldots\ldots+Pt[I(8,4)]\}$$
$$^*BER^*(1\text{-}BER)^3$$

Darin sind Pt(j) die Wahrscheinlichkeit, daß der Zeichenwert j gesendet wurde, Pr(j) die Wahrscheinlichkeit, daß der Zeichenwert j empfangen wurde und I(j,k) mit j=1,2,4,8 und k=1,2,3,4 ist der Zeichenwert, der aus j durch Negation der k-bits gebildet wurde. In den obigen Formeln ist angenommen, daß die dominierende Zahl von Fehlern als ein "Ein-bit-Fehler-pro-Zeichen"-Fehler auftritt, der maßgebend ist für kleine Wert der Bit-Fehlerrate BER.

Eine große Anzahl von Messungen offenbarten, daß Pt(1)+Pt(2)+Pt(4)+Pt(8) annähernd die Wahrscheinlichkeit von 0,42 ergibt. Daraus folgt Pt[I(i,1)]+Pt[I(i,2)]+Pt[I(i,3)]+Pt[I(i,4)]<0,6 für i=1,2,4,8 und für die Bit-Fehlerrate

$$BER<=0,05$$

$$BER^*(1\text{-}BER)^3<0,043$$

$$(1\text{-}BER)^4>0,81$$

Das erste Glied in der Gleichung für E(Nx) ist dann größer als 0,34, während das zweite Glied kleiner als 0,1 ist. Durch empirisch ermittelte Daten wurden die folgenden Ergebnisse erzielt:

$$Pr(0)=0,018$$

$$Pr(x)=0,3548$$

Folglich ist

$$VAR(N0/N)=1/N^*Pr(0)^*[1\text{-}Pr(0)]=0,0002$$

$$std(NO/N)=0,014 \text{ und}$$

$$VAR(Nx/N)=1/N^*Pr(x)^*[1\text{-}Pr(x)]=0,003$$

$$std(Nx/N)=0,055 \text{ und schließlich}$$

$$std(N0/N)/E(NO/N)=0,01>>std(Nx/N)/E(Nx/N)=0,002$$

Dadurch lassen sich folgende Näherungen rechtfertigen:

$$E(Z)=E(N0)/E(Nx)=F(BER)=BER/(1\text{-}BER)$$

$$std(Z)=std(N0/N)/Pr(x)=0,042$$

Die erste Gleichung weist darauf hin, daß innerhalb der Gültigkeitsbereiche der durchgeführten Näherungen der Durchschnittswert der Anzeigevariablen Z unabhängig von der Übertragungswahrscheinlichkeit Pt(j) ist. Um eine Anzeigenstörung std(Z) zu vermindern, ist eine gefilgerte Version Zf definiert als

$$Zf(j)=a^*Zf(j\text{-}1)+(1\text{-}a)^*Z(j\text{-}1), \text{ so daß sich ergibt:}$$

$$E[Zf(j)]=E[Z(j)] \text{ und}$$

$$VAR[Zf(j)]=(1\text{-}a)^2/(1\text{-}a^2)VAR[Z(j)].$$

Es sei angenommen, daß Zf unimodular und eher symmetrisch um seinen Durchschnittswert verteilt ist, wobei der Durchschnittswert das Maximum der zugeordneten Wahrscheinlichkeits-Dichtefunktion umfaßt. Die Schätzung Zb(j), bestimmt durch Zb(j)=inv F(Zf(j)) mit inv F als inverse Funktion von F, umfaßt eine maximale Likelihood-Schätzung der Bitfehlerrate BER und damit ist

$$\text{std}[Zb(j)]=\text{std}[Zf(j)]/F'(\text{BER}).$$

Im folgenden wird ein Vergleich mit einer ACRC-basierenden Fassung angestellt. Hierbei sind die Standard-Abweichungen für die ACRC-basierte Schätzung C und für die ADPCM-basierte Schätzung Z für eine Bit-Fehlerrate von BER=0,05 angenommen, welches als angemessener Wert für BERmax betrachtet wird.

Damit folgt für

$$P[C(j)=1]=E[C(j)]=G(\text{BER})=1-(\text{BER})^{64}=0,9625$$

$$\text{VAR}[C(J)]=E[C(j)]*\{1-E[C(j)]\}=0,036$$

$$\text{std}[C(j)]=0,19$$

$$\text{std}[Z(j)]/F'(\text{BER})=0,038$$

$$\text{std}[C(j)]/G'(\text{BER})=0,07$$

Offensichtlich ist Zb eine bessere Schätzung der Bit-Fehlerrate BER als der Wert Cb. So sind die beiden Schätzungen hergeleitet von den jeweiligen B- und A-Feldern und sind stastisch unabhängig. Folgerichtig ist die kombinierte Schätzung $Q=a*Zb+(1-a)*Cb$ mit $a=0,77$ als Füllfaktor:

$$\text{VAR}(Q)=a^{2}*\text{VAR}(Zb)+(1-a^{2})*\text{VAR}(Cb)$$

$$\text{std}(Q)=\sqrt{\text{VAR}(Q)}=0,034.$$

Damit ist die Standardabweichung nur halb so groß wie die Schätzung der Standardabweichung von Cb.

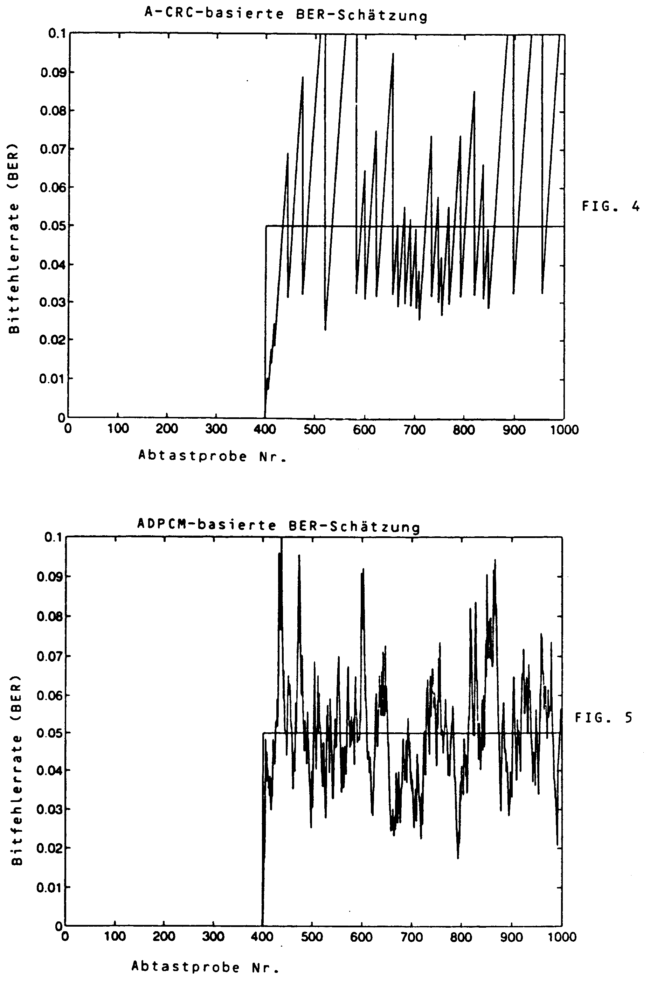

Die experimentellen Ergebnisse, wobei jeweils eine Sequenz von 1000 DECT-Rahmen oder 10 Sekunden der Audioübertragung ausgewertet wurden, zeigt anfangs keine Fehler. Danach sind die letzten 60 Rahmen verfälscht durch Bitfehler mit einer Bit-Fehlerrate von 0,05. Die Schätzungen für die ACRC- und Nullerfassung sind in der Figur 4 dargestellt.

Die Schätzungen für die ADPCM-Abtastungen für ebenfalls eine Bit-Fehlerrate von BER=0,05 zeigt die Figur 5.

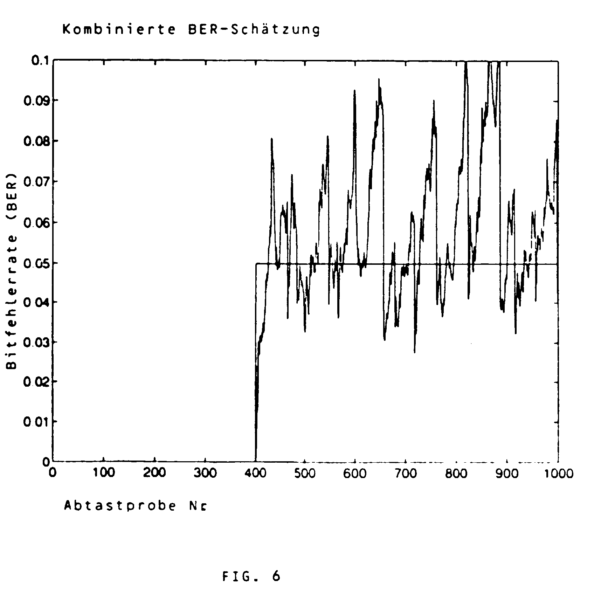

In Figur 6 ist schließlich die Kombination beider Schätzungen der Bit-Fehlerraten nach Fig. 4 und 5 grafisch dargestellt.

Zusätzlich zu den Vorteilen der Bit-Fehlerschätzung ist eine weitere Verbesserung für die ADPCM-Schätzung erzielt.

In geschäftlich genutzten DECT-Kommunikationseinrichtungen kommen interne Verbindungen über die Basisstation BS zwischen zwei mobilen Teilnehmern P1 und P2 (Fig. 3) häufig vor, wobei jeder Teilnehmer eine Funkstrecke F1, F2 zur Basisstation BS belegt. Auftretende Fehler auf den Funkstrecken F1, F2 beeinträchtigen die Tonqualität gleichmäßig auf beiden Seiten.

Es ist bisher keine Lösung bekannt, eine gleiche Übertragungqualität z. B. der Funkstrecke F1 über die Funkstrecke F2 an den Teilnehmer P2 zu übermitteln. In diesem Fall muß P2 die Stummschaltung veranlassen, ausschließlich auf die Übertragungsqualität der Funkstrecke F2 basierend. Dies kann zu Störungen führen, wenn beide Funkstrecken F1, F2 große Differenzen in der Übertragungsqualität aufweisen. Der zuvor beschriebene Algorithmus, der auf der ADPCM-Abtastung beruht, behebt dieses Problem, indem er direkt die Anzahl von Fehlern, die auf der Übertragungsstrecke zwischen P1 und P2 eintreten können, bewertet.

**Patentansprüche**

1. Verfahren zum Stummschalten von Höreinrichtungen in mobilen Kommunikations-Endgeräten, deren Funkschnittstelle zwischen Basisstation und Endgerät den DECT-Standard für das Übertragungsverfahren anwendet und das mit einer ADPCM-Datenabtastung arbeitet, dadurch gekennzeichnet, daß im Kontrolldatenfeld (A-Feld) jedes gesendeten DECT-Luftschnittstellenrahmens zur Ermittlung der Bit-Fehlerrate (BER) für eine zyklische Blockprüfung eine feste Anzahl von Nachrichteneinheiten als ACRC-Feld vorgesehen ist.

2. Verfahren nach Anspruch 1, dadurch gekennzeichnet, daß dem ACRC-Feld unmittelbar das Trägerfeld (B-Feld) für das Audio-Signal folgt.

3. Verfahren nach Anspruch 1 und 2, dadurch gekennzeichnet, daß das ACRC-Feld ein 16-Bit-Feld darstellt.

4. Verfahren nach Anspruch 1 und 2, dadurch gekennzeichnet, daß die Schätzung der Bit-Fehlerrate (BER) anhand der ADPCM-Abtastung unter Auswertung der empfangenen Nullen der Zweierkomplemente vorgenommen wird.

| A-Feld | B-Feld | X-  Z- Feld |
|---|---|---|

| 64 bit | 320 bit | CRC 4bit | 4bit |

FIG. 1

| A-Feld | B-Feld | X-  Z- Feld |
|---|---|---|

| 48bit | ACRC 16bit | 320 bit | BCRC 4bit | 4bit |

FIG. 2

BS

F1

F2

P1

P2

FIG. 3

A-CRC-basierte BER-Schätzung

FIG. 4

ADPCM-basierte BER-Schätzung

FIG. 5

Kombinierte BER-Schätzung

FIG. 6